# EUROPEAN PATENT APPLICATION

(11) **EP 2 717 097 A1**
(43) Date of publication of application: **09.04.2014**
(21) Application number: 12793730.8
(22) Date of filing: 16.05.2012
(51) Int. Cl.: G03F 7/038, B81C 1/00, C08G 59/32, G03F 7/004, G03F 7/029

(54) **PHOTOSENSITIVE RESIN COMPOSITION FOR FORMING BIOCHIP, AND BIOCHIP**

(30) Priority: 30.05.2011 JP 2011120007
(71) Applicant: Kyoto University, Sakyo-ku Kyoto-shi Kyoto 606-8501 (JP); Daicel Corporation, Osaka-shi, Osaka 530-0001 (JP)
(72) Inventor: KOTERA, Hidetoshi, Kyoto-shi, Kyoto 606-8501 (JP); OKONOGI, Atsuhito, Kyoto-shi, Kyoto 606-8501 (JP); OHOKA, Masataka, Kyoto-shi, Kyoto 606-8501 (JP); MARUO, Katsuya, Himeji-shi, Hyogo 671-1283 (JP)
(74) Representative: Grünecker, Kinkeldey, Stockmair & Schwanhäusser
(86) International application number: PCT/JP2012/062483
(87) International publication number: WO 2012/165143

(57) **Abstract**

It is intended to obtain a photosensitive resin composition that is capable of forming a highly fine pattern with a high aspect ratio while attaining the high adhesion of the pattern to a substrate, having low autofluorescence, and being exceedingly suitable for producing a biochip that causes exceedingly low damage on cultured cells. The photosensitive resin composition for forming a biochip of the present invention contains: an epoxy compound (A1) of a particular structure having an oxycyclohexane skeleton having an epoxy group; an epoxy compound (A2) of a particular structure which is a polyvalent carboxylic acid derivative having an epoxidized cyclohexenyl group; a cationic photoinitiator (B); and a solvent (C).

## Description

### Technical Field

The present invention relates to a photosensitive resin composition for forming a biochip, and a dry film resist and a biochip prepared using the same.

### Background Art

Testing devices capable of performing steps necessary for analysis, such as separation, extraction, reaction, and determination, on one chip are receiving attention as so-called biochips in medical testing, food inspection, etc. These testing devices employ substrates provided with microcapillaries, depressions, and the like.

Raw materials such as glass or silicon have conventionally been used in these substrates, and techniques including etching to which photolithography or the like is applied are used for forming the patterns as described above. Particularly, glass has low autofluorescence and is a material suitable for biochips using fluorescent detection methods. However, glass is particularly difficult to surface-treat, and in the case of DNA chips, immobilized DNA fragments may be dissociated therefrom by flowing a sample-containing solution. A further problem of glass is that a shape other than a flat.plate is difficult to prepare.

Meanwhile, studies have also been made on the application of various organic materials, particularly in consideration of the problems of the glass substrates. For example, an epoxy resin composition SU-8(TM) described in Patent Literature 1 is widely used in research areas as a photosensitive resin composition for forming a biochip. However, a cured product of SU-8(TM) has autofluorescence and thus has a disadvantage as a raw material for forming a biochip desired to attain highly sensitive fluorescent analysis. Although a method of impressing a convex pattern prepared with SU-8(TM) as a die onto PDMS (polydimethylsiloxane) or the like is generally adopted as a method for solving this disadvantage, further improvement has been demanded because not only does this method increase the number of steps of biochip preparation but also this impression step includes very complicated operation such as degassing.

Although a low autofluorescent epoxy resin is described in Patent Literature 2, the principal skeleton of its chemical structure consists of an aromatic ring which is an autofluorescent chemical species, and moreover, its practical effects are uncertain because excitation light used in autofluorescence evaluation had one wavelength more than 500 nm, which insufficiently covers the excitation wavelength ranges of fluorescent labeling substances generally used in the fluorescent analysis of biochips.

A cycloolefin copolymer having no autofluorescent site in terms of a chemical structure is used as a material for a chip substrate in Patent Literature 3. However, as the problems of the cycloolefin copolymer, it is known that: substrates having fine shapes, such as biochips are difficult to prepare, due to the high viscosity of a molten resin at a molding temperature and poor flowability; and chemical resistance is of concern.

### Citation List

### Patent Literature

Patent Literature 1: National Publication of International Patent Application No. 2007-522531
Patent Literature 2: Japanese Patent Laid-Open No. 2009-75261
Patent Literature 3: Japanese Patent No. 4292405

### Summary of Invention

### Technical Problem

An object of the present invention is to provide a photosensitive resin composition and a dry film resist that are capable of easily forming a highly fine pattern with a high aspect ratio while attaining the high adhesion of the pattern to a substrate, having low autofluorescence, and being exceedingly suitable for producing a biochip that causes exceedingly low damage on cultured cells.

Another object of the present invention is to provide a biochip that has a highly fine pattern with a high aspect ratio while having the high adhesion of the pattern to a substrate, having low autofluorescence, and causing exceedingly low damage on cultured cells.

### Solution to Problem

The present inventors have conducted diligent studies to attain the objects and consequently completed the present invention by finding that a photosensitive resin layer formed using a photosensitive resin composition containing two particular epoxy compounds, a cationic photoinitiator, and a solvent can be subjected to photolithography to thereby obtain a cured product that is excellent in adhesion to a substrate, has low autofluorescence, and is suitable for a biochip that causes exceedingly low damage on cultured cells, compared with cases using other organic materials.

Specifically, the present invention provides a photosensitive resin composition for forming a biochip, containing: an epoxy compound (A1) represented by the following formula (1):
[Formula 1] 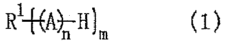
[in the formula (1), R¹ represents a residue of an organic compound having m active hydrogen(s) from which the active hydrogen(s) is excluded; A is an oxycyclohexane skeleton having a substituent and represents a group represented by the following formula (a):
[Formula 2] 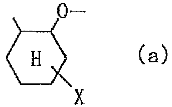
[in the formula (a), X represents any of groups of the following formulas (b), (c), and (d):
[Formula 3] 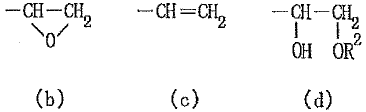
[in the formula (d), R² represents a hydrogen atom, an alkyl group, an alkylcarbonyl group, or an arylcarbonyl group]];
n represents an integer of 0 to 100; m represents an integer of 1 to 100; in the case where m is not less than 2, m groups within the parentheses may be the same as or different from each other; and in the case where n is not less than 2, n (A)s may be the same as or different from each other, provided that the formula (1) has at least one A and at least one A is represented by the formula (a) wherein X is a group represented by the formula (b)]; an epoxy compound (A2) represented by the following formula (2):
[Formula 4] 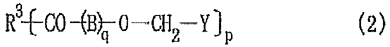
[in the formula (2), R³ represents a residue of trivalent or higher aliphatic, alicyclic, or aromatic carboxylic acid having 3 to 30 carbon atoms from which the carboxyl group is excluded; B represents a group represented by the following formula (e):
[Formula 5] 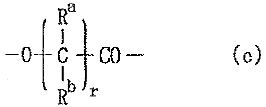
[in the formula (e), R^{a} and R^{b} are the same or different and each represent a hydrogen atom, a methyl group, or an ethyl group, r represents an integer of 4 to 8, and r groups within the parentheses may be the same as or different from each other];
Y represents a group represented by the following formula (f):
[Formula 6] 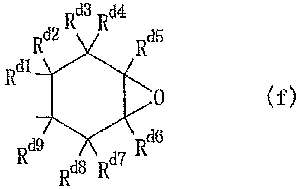
[in the formula (f), R^{d1}, R^{d2}, R^{d3}, R^{d4}, R^{d5}, R^{d6}, R^{d7}, R^{d8}, and R^{d9} are the same or different and each represent a hydrogen atom or an alkyl group having 1 to 9 carbon atoms];
q represents an integer of not less than 0; p represents an integer of not less than 3; in the case where q is not less than 2, q groups within the parentheses may be the
same as or different from each other; and p groups within the parentheses may be the same as or different from each other, provided that the formula (2) has at least one B]; a cationic photoinitiator (B); and a solvent (C).

The ratio between the epoxy compound (A1) and the epoxy compound (A2) contained therein is in the range of, for example, the former/the latter (weight ratio) = 1/99 to 99/1.

The cationic photoinitiator (B) is preferably a triarylsulfonium salt.

The solvent (C) is preferably at least one solvent selected from the group consisting of ketone-based solvents, ester-based solvents, and glycol ether-based solvents.

The present invention also provides a dry film resist comprising a base film and a photosensitive resin layer, wherein the photosensitive resin layer is formed by applying a photosensitive resin composition for forming a biochip on the base film, or wherein the photosensitive resin layer is formed by applying a photosensitive resin composition for forming a biochip on the base film and a cover film is layered on the photosensitive resin layer (a dry film resist wherein a photosensitive resin layer formed by applying the photosensitive resin composition for forming a biochip is disposed on a base film or a cover film is further layered on the photosensitive resin layer).

The present invention further provides a biochip comprising a first substrate, a photosensitive resin layer having a pattern, and a second substrate, wherein a photosensitive resin layer is formed by applying the photosensitive resin composition for forming a biochip on the first substrate and subjecting the photosensitive resin layer to photolithography to form the pattern, and the second substrate is layered on the pattern of the photosensitive resin layer having the pattern (a biochip obtained by: subjecting a photosensitive resin layer formed by applying the photosensitive resin composition for forming a biochip onto a first substrate to photolithography to form a pattern; and layering a second substrate on the pattern).

The present invention further provides a biochip comprising a substrate, a photosensitive resin layer having first pattern, and a dry film resist, wherein a photosensitive resin layer having first pattern is formed by applying the photosensitive resin composition for forming a biochip on the substrate and subjecting the photosensitive resin layer to photolithography to form the pattern, a dry film resist is layered on the first pattern of the photosensitive resin layer having first pattern so that the photosensitive resin layer of the dry film resist comes in contact with the first pattern, and a photosensitive resin layer of the dry film resist is subjected to photolithography to form a pattern (a second pattern) (a biochip obtained by: subjecting a photosensitive resin layer formed by applying the photosensitive resin composition for forming a biochip onto a substrate to photolithography to form a pattern; layering the dry film resist on the pattern so that the photosensitive resin layer of the dry film resist comes in contact with the pattern; and further subjecting the photosensitive resin layer to photolithography to form a pattern).

In this context, the biochip described in the present invention has a broad meaning including microarrays and µ-TAS (Micro Total Analysis System).

### Advantageous Effects of Invention

According to the photosensitive resin composition for forming a biochip and the dry film resist of the present invention, a highly fine pattern with a high aspect ratio can be easily formed, while a biochip that has the high adhesion of the pattern to a substrate, has low autofluorescence, and causes exceedingly low damage on cultured cells can be produced. Moreover, the biochip of the present invention has a highly fine pattern with a high aspect ratio while having the high adhesion of the pattern to a substrate, having low autofluorescence, and also causing exceedingly low damage on cultured cells.

### Description of Embodiments

The photosensitive resin composition for forming a biochip of the present invention contains an epoxy compound (A1) represented by the formula (1), an epoxy compound (A2) represented by the formula (2), a cationic photoinitiator (B), and a solvent (C).

### [Epoxy compound (A1)]

The epoxy compound (A1) is a compound represented by the formula (1). In the formula (1), R¹ represents a residue of an organic compound having m active hydrogen(s) from which the active hydrogen(s) is excluded, and A is an oxycyclohexane skeleton having a substituent and represents a group represented by the formula (a). In the formula (a), X represents any of groups of the formulas (b), (c), and (d). In the formula (d), R² represents a hydrogen atom, an alkyl group, an alkylcarbonyl group, or an arylcarbonyl group. Moreover, in the formula (1), n represents an integer of 0 to 100 (preferably an integer of 0 to 30), and m represents an integer of 1 to 100 (preferably an integer of 1 to 30, more preferably an integer of 1 to 10). In the case where m is not less than 2, m groups within the parentheses may be the same as or different from each other. Moreover, in the case where n is not less than 2, n (A)s may be the same as or different from each other. However, the formula (1) has at least one (preferably not less than 3) A, and at least one A is represented by the formula wherein X is a group represented by the formula (b). The epoxy compound (A1) can be used alone or as a mixture of not less than two. In this context, the left bond in the formula (a) of A in the formula (1) is bonded to R¹.

R¹ is a residue of an organic compound having m active hydrogen(s) from which the active hydrogen(s) is excluded (a residue that the active hydrogen(s) is excluded from an organic compound having m active hydrogen(s)), while examples of the organic compound having active hydrogen(s) which is a precursor thereof (precursor of R¹) include alcohols, phenols, carboxylic acids, amines, and thiols.

Examples of the alcohols include: monohydric alcohols such as methanol, ethanol, 1-propanol, isopropyl alcohol, 1-butanol, 1-pentanol, 1-hexanol, benzyl alcohol, and allyl alcohol; dihydric alcohols such as ethylene glycol, 1,2-propanediol, 1,3-propanediol, 1,3-butanediol, 1,4-butanediol, 1,5-pentanediol, neopentyl glycol, 1,6-hexanediol, diethylene glycol, triethylene glycol, tetraethylene glycol, polyethylene glycol, dipropylene glycol, polypropylene glycol, cyclohexanedimethanol, hydrogenated bisphenol A, hydrogenated bisphenol F, and hydrogenated bisphenol S; and trihydric or higher alcohols such as glycerin, diglycerin, polyglycerin, erythritol, trimethylolethane, trimethylolpropane, pentaerythritol, dipentaerythritol, and sorbitol. The alcohols may be polyether polyol, polyester polyol, polycarbonate polyol, polyolefin polyol, and the like. The alcohols are preferably aliphatic alcohols having 1 to 10 carbon atoms (particularly, aliphatic polyhydric alcohols having 2 to 10 carbon atoms, such as trimethylolpropane).

Examples of the phenols include phenol, cresol, catechol, pyrogallol, hydroquinone, hydroquinone monomethyl ether, bisphenol A, bisphenol F, bisphenol S, 4,4'-dihydroxybenzophenone, phenol resins, and cresol novolac resins.

Examples of the carboxylic acids include formic acid, acetic acid, propionic acid, butyric acid, fatty acids of animal or plant oils, fumaric acid, maleic acid, adipic acid, dodecanedioic acid, trimellitic acid, pyromellitic acid, polyacrylic acid, phthalic acid, isophthalic acid, and terephthalic acid. Moreover, examples thereof also include compounds having both hydroxy and carboxyl groups, such as lactic acid, citric acid, and oxycaproic acid.

Examples of the amines include methylamine, ethylamine, propylamine, butylamine, pentylamine, hexylamine, cyclohexylamine, octylamine, dodecylamine, 4,4'-diaminodiphenylamine, isophoronediamine, toluenediamine, hexamethylenediamine, xylenediamine, diethylenetriamine, triethylenetetramine, and ethanolamine.

Examples of the thiols include methylmercaptan, ethylmercaptan, propylmercaptan, phenylmercaptan, mercaptopropionic acid, and polyhydric alcohol ester of mercaptopropionic acid.

Examples of the organic compound having active hydrogen(s) other than those described above include polymers having at least one group selected from the group consisting of a hydroxy group, a carboxyl group, an amino group, and a mercapto group, such as polyvinyl alcohol, partial hydrolysates of polyvinyl acetate, starch, cellulose, cellulose acetate, cellulose acetate butyrate, hydroxyethylcellulose, acrylic polyol resins, styrene-allyl alcohol copolymerization resins, styrenemaleic acid copolymerization resins, alkyd resins, polyester polyol resins, polyester carboxylic acid resins, and polycaprolactone polyol resins.

Among those described above, an alcohol or a polymer having a hydroxy group is preferred as the organic compound having active hydrogen(s), with an alcohol particularly preferred.

In R², examples of the alkyl group include C₁₋₆ alkyl groups such as methyl and ethyl groups; examples of the alkylcarbonyl group include C₁₋₆ alkyl-carbonyl groups such as acetyl and propionyl groups; and examples of the arylcarbonyl group include C₆₋₁₀ aryl-carbonyl groups such as a benzoyl group.

The epoxy compound (A1) can be produced by a method described in, for example, Japanese Patent Laid-Open No. 60-161973 (Japanese Patent Publication No. 6-25194). For example, the epoxy compound (A1) can be produced by epoxidizing a vinyl group side chain in a polyether resin obtained by ring-opening polymerizing 4-vinylcyclohexene-1-oxide with the organic compound having m active hydrogen(s) as initiator, that is, a polycyclohexene oxide polymer having the vinyl group side chain, using an oxidizing agent such as peracid (peracetic acid, etc.). Depending on this production condition, the abundance ratios of A having the formula (b) as X, A having the formula (c) as X, and A having the formula (d) as X differ. The vinyl group represented by the formula (c) is an unreacted vinyl group that has not been epoxidized, and the group represented by the formula (d) is a group derived from a reaction solvent, peracid, or the like.

A commercially available product may be used as the epoxy compound (A1). The commercially available product is, for example, trade name "EHPE 3150" (manufactured by Daicel Corp.; solid polyfunctional aliphatic epoxy resin).

### [Epoxy compound (A2)]

The epoxy compound (A2) is a compound represented by the formula (2). In the formula (2), R³ represents a residue of trivalent or higher aliphatic, alicyclic, or aromatic carboxylic acid having 3 to 30 carbon atoms from which the carboxyl group is excluded. B represents a group represented by the formula (e). Y represents a group represented by the formula (f). In the formula (e), R^{a} and R^{b} are the same or different and each represent a hydrogen atom, a methyl group, or an ethyl group. r represents an integer of 4 to 8. r groups within the parentheses may be the same as or different from each other. In the formula (f), R^{d1}, R^{d2}, R^{d3}, R^{d4}, R^{d5}, R^{d6}, R^{d7}, R^{d8}, and R^{d9} are the same or different and each represent a hydrogen atom or an alkyl group having 1 to 9 carbon atoms (preferably 1 to 4 carbon atoms). Moreover, in the formula (2), q represents an integer of not less than 0 (for example, an integer of 0 to 100, preferably an integer of 0 to 30, more preferably an integer of 0 to 10), and p represents an integer of not less than 3 (for example, an integer of 3 to 100, preferably an integer of 3 to 30, more preferably an integer of 3 to 10). In the case where q is not less than 2, q groups within the parentheses may be the same as or different from each other. Moreover, p groups within the parentheses may be the same as or different from each other. However, the formula (2) has at least one B. The epoxy compound (A2) can be used alone or as a mixture of not less than two.

R³ is a residue of trivalent or higher aliphatic, alicyclic, or aromatic carboxylic acid having 3 to 30 carbon atoms from which the carboxyl group is excluded, while examples of the trivalent or higher aliphatic, alicyclic, or aromatic carboxylic acid having 3 to 30 carbon atoms which is a precursor thereof include propane-1,2,3-tricarboxylic acid, butane-1,2,3,4-tetracarboxylic acid, cyclohexane-1,3,5-tricarboxylic acid, trimellitic acid, and other compounds described in the paragraph of raw materials of Japanese Patent No. 2926262.

The epoxy compound (A2) can be produced by a method described in, for example, Japanese Patent No. 2926262.

A commercially available product may be used as the epoxy compound (A2). The commercially available product is, for example, trade name "Epolead GT401" (manufactured by Daicel Corp.; liquid polyfunctional alicyclic epoxy resin).

In the present invention, the epoxy compound (A1) and the epoxy compound (A2) are used in combination. In this context, the mixture of the epoxy compound (A1) and the epoxy compound (A2) is also referred to as an epoxy resin (A).

The epoxy resin (A) is preferably a low colored one, for example, one having an APHA color number of not more than 200, more preferably not more than 100, because a coloring component in the epoxy resin may be responsible for autofluorescence.

Moreover, in the case where the epoxy equivalent of the epoxy resin (A) is too small, cure shrinkage becomes large, whereby warpage or cracks easily occur in a cured product. On the other hand, in the case where the epoxy equivalent of the epoxy resin (A) is too large, crosslink density becomes small, whereby the strength of a cured coating, its adhesion to a substrate, chemical resistance, heat resistance, and crack resistance are easily reduced. From these points of view, in the present invention, the epoxy equivalent of the epoxy resin (A) is particularly preferably in the range of 175 to 205 g/eq. Therefore, the epoxy equivalent of the epoxy compound (A1) is preferably in the range of 170 to 190 g/eq., and the epoxy equivalent of the epoxy compound (A2) is preferably in the range of 200 to 300 g/eq.

Moreover, in the case where the softening point of the epoxy compound (A1) in the epoxy resin (A) is too low, a coating after application of the photosensitive resin composition of the present invention to a substrate and preliminary drying has a low tack-free surface, easily causing the adhesion of a mask during patterning. Furthermore, this case is not preferred because the photosensitive resin composition of the present invention is softened at room temperature for use as a dry film resist. On the other hand, the case where the softening point of the epoxy compound (A1) is too high is not preferred because softening for the lamination of a dry film resist to a substrate becomes difficult and laminating properties to a substrate becomes poor. From these points of view, the softening point of the epoxy compound (A1) in the epoxy resin (A) used in the present invention is preferably 50°C to 100°C, more preferably 60°C to 90°C.

In the present invention, the ratio between the epoxy compound (A1) and the epoxy compound (A2) added is not particularly limited, but is generally the former/the latter (weight ratio) = 1/99 to 99/1, preferably 10/90 to 97/3, more preferably 30/70 to 96/4, further preferably 45/55 to 95/5, particularly preferably 60/40 to 92/8. If the ratio of the epoxy compound (A2) added is too high, a coating after application of the photosensitive resin composition of the present invention to a substrate and preliminary drying has a low tack-free surface, easily causing the adhesion of a mask during patterning. On the other hand, if the ratio of the epoxy compound (A1) added is too high, the flexibility of a cured coating formed from the photosensitive resin composition of the present invention is impaired, easily causing poor crack resistance.

### [Cationic photoinitiator (B)]

In the present invention, the cationic photoinitiator (B) is not particularly limited, and a cationic photoinitiator known in the art can be used. Examples of the cationic photoinitiator include sulfonium salts (salts of sulfonium ions and anions), iodonium salts (salts of iodonium ions and anions), selenium salts (salts of selenium ions and anions), ammonium salts (salts of ammonium ions and anions), phosphonium salts (salts of phosphonium ions and anions), and salts of transition metal complex ions and anions. The cationic photoinitiator (B) can be used alone or in combination of not less than two.

Examples of the sulfonium salts include: triarylsulfonium salts such as triphenylsulfonium salt, tri-p-tolylsulfonium salt, tri-o-tolylsulfonium salt, tris(4-methoxyphenyl)sulfonium salt, 1-naphthyldiphenylsulfonium salt, 2-naphthyldiphenylsulfonium salt, tris(4-fluorophenyl)sulfonium salt, tri-1-naphthylsulfonium salt, tri-2-naphthylsulfonium salt, tris(4-hydroxyphenyl)sulfonium salt, diphenyl[4-(phenylthio)phenyl]sulfonium salt, and 4-(p-tolylthio)phenyl di-(p-phenyl)sulfonium salt; diarylsulfonium salts such as diphenylphenacylsulfonium salt, diphenyl-4-nitrophenacylsulfonium salt, diphenylbenzylsulfonium salt, and diphenylmethylsulfonium salt; monoarylsulfonium salts such as phenylmethylbenzylsulfonium salt, 4-hydroxyphenylmethylbenzylsulfonium salt, and 4-methoxyphenylmethylbenzylsulfonium salt; and trialkylsulfonium salts such as dimethylphenacylsulfonium salt, phenacyltetrahydrothiophenium salt, and dimethylbenzylsulfonium salt.

Examples of the iodonium salts include diphenyliodonium salt, di-p-tolyliodonium salt, bis(4-dodecylphenyl)iodonium salt, and bis(4-methoxyphenyl)iodonium salt.

Examples of the selenium salts include: triarylselenium salts such as triphenylselenium salt, tri-p-tolylselenium salt, tri-o-tolylselenium salt, tris(4-methoxyphenyl)selenium salt, and 1-naphthyldiphenylselenium salt; diarylselenium salts such as diphenylphenacylselenium salt, diphenylbenzylselenium salt, and diphenylmethylselenium salt; monoarylselenium salts such as phenylmethylbenzylselenium salt; and trialkylselenium salts such as dimethylphenacylselenium salt.

Examples of the ammonium salts include: tetraalkylammonium salts such as tetramethylammonium salt, ethyltrimethylammonium salt, diethyldimethylammonium salt, triethylmethylammonium salt, tetraethylammonium salt, trimethyl-n-propylammonium salt, and trimethyl-n-butylammonium salt; pyrrolidinium salts such as N,N-dimethylpyrrolidinium salt and N-ethyl-N-methylpyrrolidinium salt; imidazolinium salts such as N,N'-dimethylimidazolinium salt and N,N'-diethylimidazolinium salt; tetrahydropyrimidinium salts such as N,N'-dimethyltetrahydropyrimidinium salt and N,N'-diethyltetrahydropyrimidinium salt; morpholinium salts such as N,N-dimethylmorpholinium salt and N,N-diethylmorpholinium salt; N,N-dimethylpiperidinium salt and N,N-diethylpiperidinium salt; pyridinium salts such as N-methylpyridinium salt and N-ethylpyridinium salt; imidazolium salts such as N,N'-dimethylimidazolium salt; quinolinium salts such as N-methylquinolinium salt; isoquinolinium salts such as N-methylisoquinolinium salt; thiazolium salts such as benzylbenzothiazolium salt; and acridinium salts such as benzylacridinium salt.

Examples of the phosphonium salts include: tetraarylphosphonium salts such as tetraphenylphosphonium salt, tetra-p-tolylphosphonium salt, and tetrakis(2-methoxyphenyl)phosphonium salt; triarylphosphonium salts such as triphenylbenzylphosphonium salt; and tetraalkylphosphonium salts such as triethylbenzylphosphonium salt, tributylbenzylphosphonium salt, tetraethylphosphonium salt, tetrabutylphosphonium salt, and triethylphenacylphosphonium salt.

Examples of the salts of transition metal complex ions include: salts of chromium complex cations such as (η5-cyclopentadienyl) (η6-toluene)Cr⁺ and (η5-cyclopentadienyl) (η6-xylene)Cr⁺; and salts of iron complex cations such as (η5-cyclopentadienyl) (η6-toluene)Fe⁺ and (η5-cyclopentadienyl) (η6-xylene) Fe⁺.

Examples of the anions (counterions) for forming salts with the cations include SbF₆⁻, PF₆⁻, BF₄⁻, (CF₃CF₂)₃PF₃⁻, (F₃CF₂CF₂)₃PF₃⁻, (C₆F₅)₄B⁻, (C₆F₅)₄Ga⁻, sulfonic acid anions (trifluoromethanesulfonic acid anions, pentafluoroethanesulfonic acid anions, nonafluorobutanesulfonic acid anions, methanesulfonic acid anions, benzenesulfonic acid anions, and p-toluenesulfonic acid anions), (CF₃SO₂)₃C⁻, (CF₃SO₂)₂N⁻, perhalogen acid ions, sulfonic acid halide ions, sulfuric acid ions, carbonic acid ions, aluminic acid ions, hexafluorobismuthic acid ions, carboxylic acid ions, arylboric acid ions, thiocyanic acid ions, and nitric acid ions.

The cationic photoinitiator (B) in the present invention is preferably one that hardly emits fluorescence when the resin composition is irradiated with light having a wavelength in the visible region. Specific examples of the cationic photoinitiator having such properties can include triarylsulfonium salts such as triphenylsulfonium salt, tri-o-tolylsulfonium salt, tris(4-methoxyphenyl)sulfonium salt, and diphenyl[4-(phenylthio)phenyl]sulfonium salt. Of them, diphenyl[4-(phenylthio)phenyl]sulfonium salt is particularly preferred because of being less contaminated with fluorescent impurities and being excellent in the ability to generate acids upon light irradiation. Moreover, the counter ions (anions) are particularly preferably hexafluoroantimonic acid ions, tris(pentafluoroethyl)trifluorophosphoric acid ions, hexafluorophosphoric acid ions, and the like.

The diphenyl[4-(phenylthio)phenyl]sulfonium salt is produced by a method described in U.S. Patent No. 4231951, while the diphenyl[4-(phenylthio)phenyl]sulfonium salt used in the present invention is preferably one substantially containing no dimer as a by-product. Specific examples of such diphenyl[4-(phenylthio)phenyl]sulfonium salt include trade name "CPI-101A" (manufactured by San-Apro Ltd.; 50% solution of diphenyl[4-(phenylthio)phenyl]sulfonium hexafluoroantimonate in propylene carbonate), trade name "CPI-100P" (manufactured by San-Apro Ltd.; 50% solution of diphenyl[4-(phenylthio)phenyl]sulfonium hexafluorophosphate in propylene carbonate), and trade name "K1-S" (manufactured by San-Apro Ltd.; non-antimony-based triarylsulfonium salt).

In this context, particularly, trade name "CPI-100P" (manufactured by San-Apro Ltd.; 50% solution of diphenyl[4-(phenylthio)phenyl]sulfonium hexafluorophosphate in propylene carbonate) or trade name "K1-S" (manufactured by San-Apro Ltd.; non-antimony-based triarylsulfonium salt) is preferred as the cationic photoinitiator (B) in consideration of the provision of nontoxicity to and low damage on biological substances (for example, DNA, proteins, and cells) which is a challenge to the case where biochip substrates are prepared using organic materials. Particularly, in the case where trade name "CPI-100P" (manufactured by San-Apro Ltd.; 50% solution of diphenyl[4-(phenylthio)phenyl]sulfonium hexafluorophosphate in propylene carbonate) was used, cell growth was favorable during the culture of cells on the surface of a coating of the epoxy resin (A) of the present invention, and remarkable improvement was seen in peeling resistance from a glass substrate dipped in a culture solution. Accordingly, trade name "CPI-100P" (manufactured by San-Apro Ltd.; 50% solution of diphenyl[4-(phenylthio)phenyl]sulfonium hexafluorophosphate in propylene carbonate) is particularly preferably used as the cationic photoinitiator (B).

In the case where the content of the cationic photoinitiator (B) is too small in the photosensitive resin composition for forming a biochip of the present invention, a sufficient curing rate becomes difficult to attain. Moreover, the case where the cationic photoinitiator (B) is contained in a large amount more than needs is not economic. From these points of view, the proportion of the cationic photoinitiator (B) used in the photosensitive resin composition for forming a biochip of the present invention is, for example, 1 to 20 parts by weight, preferably 4 to 12 parts by weight, with respect to 100 parts by weight of the epoxy resin (A) [total amount of the epoxy compound (A1) and the epoxy compound (A2)].

### [Solvent (C)]

In the present invention, the solvent (C) is not particularly limited and can be used alone or by mixing not less than two solvents. The solvent (C) is preferably a solvent that less emits fluorescence by itself and is further unlikely to form a by-product emitting autofluorescence through side reaction that occurs during light irradiation and thermal curing. Specific examples of such a solvent include: ketone-based solvents such as acetone, methyl ethyl ketone, methyl isobutyl ketone, cyclopentanone, and cyclohexanone; ester-based solvents such as ethyl acetate, methoxybutyl acetate, and propylene glycol monomethyl ether acetate; and various glycol ether-based solvents such as propylene glycol monomethyl ether, dipropylene glycol monomethyl ether, propylene glycol monopropyl ether, and dipropylene glycol monopropyl ether. Among them, cyclopentanone is particularly preferred from the viewpoint of being unlikely to form fluorescent materials and of drying properties.

The solvent (C) is added for the purpose of adjusting film thickness or coating properties when the photosensitive resin composition is applied to a substrate. The content of the solvent (C) in the photosensitive resin composition for forming a biochip is usually 5 to 95% by weight, preferably 25 to 60% by weight, for correctly maintaining solubility in the epoxy resin (A) and the cationic photoinitiator (B), its volatility, and liquid viscosity as a coating solution.

### [Other components]

The photosensitive resin composition for forming a biochip of the present invention can be supplemented with various additives without departing from the spirit of the present invention in order to further improve performance. In the case of adding the additives, it is preferred to use additives that have no autofluorescence by themselves and do not form by-products emitting autofluorescence through reaction with the cationic photoinitiator (B) used. Examples of the additives used for such a purpose include cationically photopolymerizable compounds other than the epoxy resin (A) which is an essential component of the present invention, interfacial function-imparting agents, and other additives.

A compound that is miscible with the photosensitive resin composition for forming a biochip of the present invention is used as the cationically photopolymerizable compound other than the epoxy resin (A). Examples of such a cationically photopolymerizable compound include alicyclic epoxy compounds, aliphatic epoxy compounds, cyclic ether compounds, cyclic lactone compounds, cyclic acetal compounds, cyclic thioether compounds, spiro ortho-ester compounds, and vinyl compounds. One or not less than two of these compounds can be used. Particularly, an epoxy compound is suitable because it is easily available and conveniently handleable.

Specific examples of the alicyclic epoxy compounds are ones other than the epoxy resin (A) which is an essential component of the present invention and include polyglycidyl ethers of polyhydric alcohols having at least one alicyclic ring, and cyclohexene oxide or cyclopentene oxide-containing compounds obtained by epoxidizing cyclohexene or cyclopentene ring-containing compounds using an oxidizing agent.

Examples of the alicyclic epoxy compounds include hydrogenated bisphenol A diglycidyl ether, 3,4-epoxycyclohexylmethyl-3,4-epoxycyclohexanecarboxylate, 3,4-epoxy-1-methylcyclohexyl-3,4-epoxy-1-methylcyclohexanecarboxylate, 6-methyl-3,4-epoxycyclohexylmethyl-6-methyl-3,4-epoxycyclohexanecarboxylate, 3,4-epoxy-3-methylcyclohexylmethyl-3,4-epoxy-3-methylcyclohexanecarboxylate, 3,4-epoxy-5-methylcyclohexylmethyl-3,4-epoxy-5-methylcyclohexanecarboxylate, 2-(3,4-epoxycyclohexyl-5,5-spiro-3,4-epoxy)cyclohexane-metadioxane, bis(3,4-epoxycyclohexyl), bis(3,4-epoxycyclohexylmethyl)adipate, vinylcyclohexene dioxide, 4-vinylepoxycyclohexane, bis(3,4-epoxy-6-methylcyclohexylmethyl)adipate, 3,4-epoxy-6-methylcyclohexylcarboxylate, methylenebis(3,4-epoxycyclohexane), dicyclopentadiene diepoxide, 3,4-epoxycyclohexylmethyl alcohol, ethylene glycol di(3,4-epoxycyclohexylmethyl) ether, ethylenebis(3,4-epoxycyclohexanecarboxylate), dioctyl epoxyhexahydrophthalate, di-2-ethylhexyl epoxyhexahydrophthalate, and 3,4-epoxycyclohexylethyltrimethoxysilane.

Specific examples of the aliphatic epoxy compounds include polyglycidyl ethers of aliphatic polyhydric alcohols or their alkylene oxide adducts, polyglycidyl esters of aliphatic long-chain polybasic acids, homopolymers synthesized by the vinyl polymerization of glycidyl acrylate or glycidyl methacrylate, and copolymers synthesized by the vinyl polymerization of glycidyl acrylate or glycidyl methacrylate and other vinyl monomers.

Typical examples of the aliphatic epoxy compounds include 1,4-butanediol diglycidyl ether, 1,6-hexanediol diglycidyl ether, triglycidyl ether of glycerin, triglycidyl ether of trimethylolpropane, tetraglycidyl ether of sorbitol, hexaglycidyl ether of dipentaerythritol, diglycidyl ether of polyethylene glycol, glycidyl ethers of polyhydric alcohols such as diglycidyl ether of polypropylene glycol, polyglycidyl ether of polyether polyol obtained by adding one or not less than two alkylene oxides to an aliphatic polyhydric alcohol such as propylene glycol, trimethylolpropane, or glycerin, and diglycidyl ester of aliphatic long-chain dibasic acid. Furthermore, monoglycidyl ether of an aliphatic higher alcohol, glycidyl ester of higher fatty acid, epoxidized soybean oil, octyl epoxy stearate, butyl epoxy stearate, epoxidized linseed oil, epoxidized polybutadiene, or the like may be used.

Specific examples of the cationically photopolymerizable compounds other than the epoxy compounds described above include: oxetane compounds such as trimethylene oxide, 3,3-dimethyloxetane, and 3,3-dichloromethyloxetane; cyclic ether compounds such as tetrahydrofuran, trioxane such as 2,3-dimethyltetrahydrofuran, 1,3-dioxolane, and 1,3,6-trioxacyclooctane; cyclic lactone compounds such as β-propiolactone, γ-butyrolactone, and ε-caprolactone; thiirane compounds such as ethylene sulfide; thietane compounds such as trimethylene sulfide and 3,3-dimethylthietane; cyclic thioether compounds such as tetrahydrothiophene derivatives; spiro ortho-ester compounds, spiro ortho-carbonate compounds, and cyclic carbonate compounds obtained through reaction between an epoxy compound and lactone; vinyl ether compounds such as ethylene glycol divinyl ether, alkylvinyl ether, 3,4-dihydropyran-2-methyl(3,4-dihydropyran-2-carboxylate), and triethylene glycol divinyl ether; ethylenic unsaturated compounds such as styrene, vinylcyclohexene, isobutylene, and polybutadiene; and derivatives of those described above.

The amount of the cationically photopolymerizable compound added other than the epoxy resin (A) which is an essential component of the present invention is preferably not more than 100 parts by weight, more preferably not more than 50 parts by weight, particularly preferably not more than 20 parts by weight, with respect to 100 parts by weight of the epoxy resin (A) [total amount of the epoxy compound (A1) and the epoxy compound (A2)].

In the present invention, an interfacial function-imparting agent may be added for the purpose of imparting affinity for biological substances (for example, DNA, proteins, and cells). The function of the interfacial function-imparting agent is not particularly limited as long as the function is capable of controlling the balance between hydrophobicity and hydrophilicity of coating surface, and various surfactants or polyols can be used. These interfacial function-imparting agents can be used alone or in combination of not less than two. If the interfacial function-imparting agent is used in a large amount, reduction in the peeling resistance of the coating from a substrate may be caused or patterning properties may be deteriorated. Since the interfacial function-imparting agent even in a small amount exerts effects, use within a range that has no adverse influence is appropriate.

Various additives such as thermoplastic resins, thickeners, antifoaming agents, and leveling agents can be used as other additives in the photosensitive resin composition for forming a biochip of the present invention. In the case of using these additives, the amount of each additive added is on the order of 0.1 to 20 parts by weight, as a tentative guideline, with respect to 100 parts by weight of the photosensitive resin composition for forming a biochip of the present invention, but can be increased or decreased appropriately according to the use purpose.

The photosensitive resin composition for forming a biochip of the present invention may be further supplemented with, for example, an inorganic filler such as barium sulfate, barium titanate, silicon oxide, amorphous silica, talc, clay, magnesium carbonate, calcium carbonate, aluminum oxide, aluminum hydroxide, or mica.

The photosensitive resin composition for forming a biochip of the present invention can be prepared by adding together the epoxy resin (A) [epoxy compound (A1) and epoxy compound (A2)], the cationic photoinitiator (B), the solvent (C), and, if necessary, other components, preferably at the proportions described above, and uniformly mixing, dissolving, or dispersing them using a stirrer such as a dissolver. In a preferred aspect, the photosensitive resin composition for forming a biochip of the present invention is used in a liquid state.

The photosensitive resin composition for forming a biochip of the present invention can be subjected to photolithography to thereby form a highly fine pattern with a high aspect ratio. For example, a permanently cured firm (pattern) that satisfies various properties can be obtained by: applying the photosensitive resin composition at a thickness of, for example, 1 to 1000 µm (preferably a thickness of 10 to 200 µm) onto a substrate such as glass or a silicon wafer using a spin coater or the like; for solvent removal, heating the applied resin composition at, for example, 40°C to 130°C for approximately 5 minutes to 24 hours to form a layer of the photosensitive resin composition; then placing thereon a mask having a predetermined pattern; irradiating the mask with UV rays at an energy quantity of, for example, 10 to 10000 mJ/cm² using a light source such as a high-pressure mercury vapor lamp; performing heat treatment at, for example, 50 to 130°C for approximately 1 to 60 minutes; then developing unexposed portions at room temperature to 50°C for approximately 1 to 180 minutes using a developer to form a pattern; and if necessary, further performing heat treatment.

Although the developer is not particularly limited, for example, an organic solvent such as γ-butyrolactone, triethylene glycol dimethyl ether, or propylene glycol monomethyl ether acetate, or a mixed solution of the organic solvent and water can be used. The development may employ a dipping method or a developing apparatus of paddle type, spray type, shower type, or the like, and if necessary, ultrasonic irradiation may be performed.

A molded product can be prepared from the photosensitive resin composition for forming a biochip of the present invention by various methods known per se in the art.

### [Dry film resist]

In the dry film resist of the present invention, a photosensitive resin layer formed by applying the photosensitive resin composition for forming a biochip of the present invention is disposed on a base film. A cover film may be further layered on the photosensitive resin layer.

The dry film resist of the present invention can be produced, for example, by: applying the photosensitive resin composition for forming a biochip of the present invention onto a base film (base material) using, for example, a roll coater, a die coater, a knife coater, a bar coater, or a gravure coater; then drying the applied resin composition in a drying oven set to, for example, 45 to 100°C; removing a predetermined amount of the solvent; and if necessary, layering thereon a cover film (base material) or the like. In this respect, the thickness of the resist on the base film is adjusted to, for example, 2 to 100 µm.

Polymer films, for example, polyester, polypropylene, polyethylene, triacetylcellulose, or polyimide, may be used as the base film and the cover film. These films may be subjected, if necessary, to mold release treatment with a silicon-based mold release agent, non-silicon-based mold release agent, or the like.

For using such a dry film resist, for example, the cover film is removed therefrom, and the resulting resist can be transferred to a substrate, a support, or the like under conditions involving 40 to 100°C and a pressure of 0.5 to 20 kgf/cm² using a hand roller, a laminator, or the like and subjected to exposure, post-exposure heat treatment, development, and heat treatment in the same way as above.

If the photosensitive resin composition for forming a biochip of the present invention is processed into a dry film resist and used, the steps of application onto a support or a substrate and drying can be omitted to thereby achieve more convenient pattern formation using the photosensitive resin composition for forming a biochip of the present invention.

### [Biochip]

The biochip according to the present invention is provided one in which a device such as a fine channel (microchannel) of a few µm to a few hundreds of µm or a mixer, a detection unit, or the like is disposed on a substrate in order to subject the biochip to medical testing or food inspection and perform various biochemical or chemical processes such as cell culture, cell sorters, biochemical analysis, environmental analysis, and chemical synthesis. The biochip may be provided, if necessary, with an injection hole for adding drug solutions.

The first biochip of the present invention is a layered product obtained by: subjecting a photosensitive resin layer formed by applying the photosensitive resin composition for forming a biochip of the present invention onto a first substrate to photolithography to form a pattern; and layering a second substrate on the pattern. A substrate provided with an inlet for adding drug solutions may be used as the second substrate.

Moreover, the second biochip of the present invention is a layered product obtained by: subjecting a photosensitive resin layer formed by applying the photosensitive resin composition for forming a biochip of the present invention onto a substrate to photolithography to form a pattern; layering the dry film resist on the pattern so that the photosensitive resin layer of the dry film resist comes in contact with the pattern; and further subjecting the photosensitive resin layer to photolithography to form a pattern.

The substrate can be any substrate that permits uniform formation of the photosensitive resin layer and does not cause dissolution, deformation, or the like during the formation of the photosensitive resin layer and even in the subsequent steps. Examples of such a substrate include ones prepared with inorganic materials such as silicone, quartz, glass, sapphire, metals, and ceramics or organic materials such as polyimide resins and acrylic resins. Moreover, in the case of performing the observation or photometric analysis of channels or the like, one excellent in light permeability is preferred, and examples thereof include: inorganic materials such as quartz and glass; and plastic materials such as acrylic resins, polycarbonate resins, and cycloolefin copolymers.

The formation of a pattern such as a channel pattern by photolithography can be performed in the same way as above.

Since the pattern serving as a channel or the like is constituted by a cured product of two particular epoxy compounds, the biochip of the present invention attains a high aspect ratio (width-to-height ratio of a resist pattern) and high fineness of a pattern, has the high adhesion of the pattern to a substrate, has low autofluorescence, and has the property of causing exceedingly low damage on cultured cells.

### Example

Although the present invention will be described below in more detail with reference to Example, the present invention is not limited by this Example by any means. In Example and Comparative Example, part and % mean part by weight and % by weight, respectively, unless otherwise specified.

### Example 1

Fifty parts of trade name "EHPE 3150" manufactured by Daicel Corp. [1,2-epoxy-4-(2-oxiranyl)cyclohexane adduct of 2,2-bis(hydroxymethyl)-1-butanol; solid polyfunctional alicyclic epoxy resin], 10 parts of trade name "Epolead GT401" manufactured by Daicel Corp. [epoxidized tetrakis-(3-cyclohexenylmethyl)butanetetracarboxylate-modified ε-caprolactone; liquid polyfunctional alicyclic epoxy resin], 5.5 parts of a cationic photoinitiator (manufactured by San-Apro Ltd., trade name "CPI-100P"; 50% solution of diphenyl[4-(phenylthio)phenyl]sulfonium hexafluorophosphate in propylene carbonate), and 50 parts of cyclopentanone (solvent) were mixed by stirring to prepare a photosensitive resin composition.

The obtained photosensitive resin composition was uniformly applied onto a hexamethyldisilazane (HMDS)-coated glass substrate (2 cm x 2 cm) using a spin coater to form a photosensitive resin composition layer. In this context, the coating of HMDS onto the surface of the glass substrate (dried at 80°C for 5 minutes in a hot plate after application using a spin coater) is intended to improve the adhesion of the epoxy resin to the glass substrate. The formed photosensitive resin composition layer was subjected to pre-exposure baking at 65°C for 5 minutes and at 95°C for 20 minutes in a hot plate. Then, exposure was performed at an exposure dose that attained the best precision during mask transfer using an exposure apparatus (manufactured by Nanotec Corporation, one-side mask aligner LA310; light irradiation at a wavelength of not less than 350 nm). Post-exposure baking (PEB) at 65°C for 1 minute and at 95°C for 5 minutes was performed in a hot plate, and development treatment at 23°C for 2 minutes to 10 minutes was performed by a dipping method using a developer manufactured by Nippon Kayaku Co., Ltd. (trade name "SU-8 developer"), followed by rinsing by a dipping method at 23°C for 1 minute to 5 minutes in isopropyl alcohol to thereby obtain a coating cured on the substrate, and a pattern.

### Comparative Example 1

A coating cured on a substrate, and a pattern were obtained in the same way as in Example 1 except that a photocurable epoxy resin composition manufactured by Nippon Kayaku Co., Ltd. (trade name "SU-8 3010"; cationic photopolymerization catalyst-containing epoxy resin composition) was used as a photosensitive resin composition.

### Evaluation test

Each cured coating obtained in Example and Comparative Example was evaluated as described below. The results are shown in Table 1. In (2) and (3) described below, DMEM-10% FBS [DMEM (Dulbecco's modified eagle's medium; manufactured by Sigma-Aldrich Corp.) supplemented with FBS (fetal bovine serum; manufactured by Sigma-Aldrich Corp.) corresponding to 10% by volume ratio] was used as a medium.

### (1) Low autofluorescence

Each sample was excited at 365 nm using a spectrophotometer F-4500 manufactured by Hitachi, Ltd., and fluorescence intensity in the maximum fluorescence wavelength region (430 nm) was compared between the samples.

### (2) Peeling resistance from glass substrate in culture solution

Each glass substrate in which a cured coating was formed on the surface was put in a 3.5-cm dish and subjected to sterilization treatment at 60°C for 36 hours. A cell suspension (2.5 × 10⁵ cells/ml) was prepared from MIN6-m9 cells cultured until 100% confluence and added dropwise in an amount of 1 ml, together with 2.5 ml of the medium, to the 3.5-cm dish containing each plate. Subsequently, the dish was put in a 5% CO₂ incubator, the cells were cultured, and the state of the coating was photographed every other day to evaluate peeling resistance.

### (3) Low damage on cultured cell

Each glass substrate in which a cured coating was formed on the surface was put in a 3.5-cm dish and subjected to sterilization treatment at 60°C for 36 hours. A cell suspension (2.5 × 10⁵ cells/ml) was prepared from MIN6-m9 cells cultured until 100% confluence and added dropwise in an amount of 1 ml, together with 2.5 ml of the medium, to the 3.5-cm dish containing each plate. Subsequently, the dish was put in a 5% CO₂ incubator, the cells were cultured, and the state of the cells was photographed every other day. The growth rate and morphology of the cells were compared among the samples from the photographing results to evaluate damage on the cells. The results obtained on the first day from the start of cell culture are shown in Table 1.

In this context, the cells were cultured in the same way as above except that a 2 cm x 2 cm glass substrate (treated, on the surface, with oxygen plasma) was used as a control (Reference Example 1) instead of the glass substrate in which a cured coating was formed on the surface.

In Table 1, "Relative growth rate of cell" is a relative value to a growth rate on the glass substrate (Reference Example 1) defined as 10. Regarding "Cell morphology", the morphology progresses from particulate forms to flat and amorphous forms as the cell growth progresses. "Overall evaluation" is a relative value to overall evaluation on the glass substrate (Reference Example 1) defined as 10.

[Table 1]

**Table 1**

| | | Example 1 | Comparative Example 1 | Reference Example 1 (control) |
|---|---|---|---|---|
| Low autofluorescence | Relative fluorescence intensity | 0.6 | 1.0 | - |
| Peeling resistance | | Not peeled even on 10th day from start of test | Peeled on 2nd day from start of test | - |
| Low damage on cultured cell | Relative growth rate of cell | 8 | 0 | 10 |
| | Cell morphology | Flat and amorphous | Particulate | Flat and amorphous |
| | Overall evaluation | 8 | 0 | 10 |

### Industrial Applicability

A biochip produced using the photosensitive resin composition for forming a biochip of the present invention causes reduced damage on cells and eliminates the need of a crimping tool for avoiding peeling during use because the coating is not peeled from a substrate during culture. In addition, discrimination is achieved with higher sensitive than ever for differentiating the types of cultured cells or observing the life and death of the cells under fluorescence microscope, because the autofluorescence of the coating is reduced. Thus, the photosensitive resin composition for forming a biochip of the present invention can be suitably used as a material for forming a biochip.

## Claims

1. A photosensitive resin composition for forming a biochip, containing: an epoxy compound (A1) represented by the following formula (1):
[Formula 1] 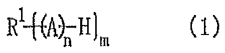
[in the formula (1), R¹ represents a residue of an organic compound having m active hydrogen(s) from which the active hydrogen(s) is excluded; A is an oxycyclohexane skeleton having a substituent and
represents a group represented by the following formula (a):
[Formula 2] 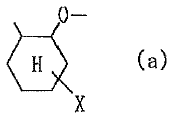
[in the formula (a), X represents any of groups of the following formulas (b), (c), and (d):
[Formula 3] 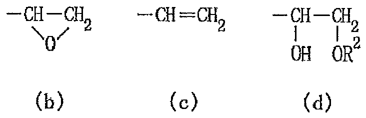
[in the formula (d), R² represents a hydrogen atom, an alkyl group, an alkylcarbonyl group, or an arylcarbonyl group]];
n represents an integer of 0 to 100; m represents an integer of 1 to 100; in the case where m is not less than 2, m groups within the parentheses may be the same as or different from each other; and in the case where n is not less than 2, n (A)s may be the same as or different from each other, provided that the formula (1) has at least one A and at least one A is represented by the formula (a) wherein X is a group represented by the formula (b)]; an epoxy compound (A2) represented by the following formula (2):
[Formula 4] 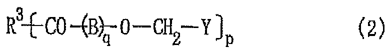
[in the formula (2), R³ represents a residue of trivalent or higher aliphatic, alicyclic, or aromatic carboxylic acid having 3 to 30 carbon atoms from which the carboxyl group is excluded; B represents a group represented by the following formula (e):
[Formula 5] 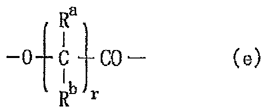
[in the formula (e), R^{a} and R^{b} are the same or different and each represent a hydrogen atom, a methyl group, or an ethyl group, r represents an integer of 4 to 8, and r groups within the parentheses may be the same as or
different from each other];
Y represents a group represented by the following formula (f):
[Formula 6] 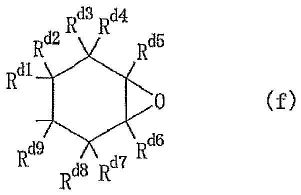
[in the formula (f), R^{d1}, R^{d2}, R^{d3}, R^{d4}, R^{d5}, R^{d6}, R^{d7}, R^{d8}, and R^{d9} are the same or different and each represent a hydrogen atom or an alkyl group having 1 to 9 carbon atoms];
q represents an integer of not less than 0; p represents an integer of not less than 3; in the case where q is not less than 2, q (B)s may be the same as or different from each other; and p groups within the parentheses may be the same as or different from each other, provided that the formula (2) has at least one B];
a cationic photoinitiator (B); and a solvent (C).

2. The photosensitive resin composition for forming a biochip according to claim 1, wherein the ratio between the epoxy compound (A1) and the epoxy compound (A2) contained therein is the former/the latter (weight ratio) = 1/99 to 99/1.

3. The photosensitive resin composition for forming a biochip according to claim 1 or 2, wherein the cationic photoinitiator (B) is a triarylsulfonium salt.

4. The photosensitive resin composition for forming a biochip according to any one of claims 1 to 3, wherein the solvent (C) is at least one solvent selected from the group consisting of ketone-based solvents, ester-based solvents, and glycol ether-based solvents.

5. A dry film resist comprising a base film and a photosensitive resin layer, wherein the photosensitive resin layer is formed by applying a photosensitive resin composition for forming a biochip according to any one of claims 1 to 4 on the base film, or wherein the photosensitive resin layer is formed by applying a photosensitive resin composition for forming a biochip according to any one of claims 1 to 4 on the base film and a cover film is layered on the photosensitive resin layer.

6. A biochip comprising a first substrate, a photosensitive resin layer having a pattern, and a second substrate,
wherein the photosensitive resin layer is formed by applying the photosensitive resin composition for forming a biochip according to any one of claims 1 to 4 on the first substrate and subjecting the photosensitive resin layer to photolithography to form the pattern, and the second substrate is layered on the pattern of the photosensitive resin layer having the pattern.

7. A biochip comprising a substrate, a photosensitive resin layer having first pattern, and a dry film resist, wherein a photosensitive resin layer having first pattern is formed by applying the photosensitive resin composition for forming a biochip according to any one of claims 1 to 4 on the substrate and subjecting the photosensitive resin layer to photolithography to form the pattern, a dry film resist according to claim 5 is layered on the first pattern of the photosensitive resin layer having first pattern so that the photosensitive resin layer of the dry film resist comes in contact with the first pattern, and a photosensitive resin layer of the dry film resist is subjected to photolithography to form a pattern.
